# EUROPEAN PATENT APPLICATION

(11) **EP 2 690 682 A1**
(43) Date of publication of application: **29.01.2014**
(21) Application number: 11861768.7
(22) Date of filing: 22.03.2011
(51) Int. Cl.: H01L 51/52, H05B 33/26

(54) **ORGANIC ELECTROLUMINESCENT DEVICE AND CONDUCTIVE BASE THEREOF**

(71) Applicant: Ocean's King Lighting Science&Technology Co., Ltd., Shenzhen, Guangdong 518054 (CN)
(72) Inventor: ZHOU, Mingjie, Shenzhen Guangdong 518054 (CN); WANG, Ping, Shenzhen Guangdong 518054 (CN); HUANG, Hui, Shenzhen Guangdong 518054 (CN); CHEN, Jixing, Shenzhen Guangdong 518054 (CN)
(74) Representative: Michalski, Stefan
(86) International application number: PCT/CN2011/072024
(87) International publication number: WO 2012/126175

(57) **Abstract**

An organic electroluminescent device and a conductive substrate thereof are provided. Said conductive substrate includes a glass substrate, an indium tin oxide (ITO) layer and a metal oxide layer located between said glass substrate and said ITO layer. The refractive index of said metal oxide layer ranges between that of said glass substrate and said ITO layer. Due to the metal oxide layer, the refractive index of which ranges between that of the glass substrate and the ITO layer, is inserted into said conductive substrate, when the light extracts between the ITO/metal oxide layer and the metal oxide layer/glass, the critical angle of total reflection increases compared with that without the inserted metal oxide layer. Most part of light extracts out of the interface after refraction, and only small part of light is totally reflected, thus the light extraction enhances.

## Description

### FIELD OF THE INVENTION

The present disclosure relates to an organic electroluminescent device and a conductive substrate thereof.

### BACKGROUND OF THE INVENTION

In 1987, C. W. Tang and Van Slyke of Eastman Kodak of the United States reported a breakthrough in electroluminescent research. A two-layer small molecule organic electroluminescent device (OLED) with high luminance and high efficiency was prepared using a thin film technology. As for the two-layer device, the luminance was up to 1000 cd/m² at an operation voltage of 10V, the luminous efficiency was 1.51 lm/W, the lifetime was more than 100 hours.

The working principle of OLED is that, during operation, a voltage is applied, electrons are injected into the LUMO (The unoccupied molecular orbitals) of the organic layer at the cathode, while holes are injected into the HOMO (The highest occupied molecular orbitals). Electrostatic forces bring the electrons and the holes towards each other and they recombine forming an exciton, which migrates in the electric field and transfers the energy to the luminescent materials and excites electrons from the ground state to the excited state. The decay of this excited state results in a relaxation of the energy levels of the electron, accompanied by emission of radiation whose frequency is in the visible region. However, in the emitting light from the light-emitting layer, only about 25% of the total luminescent light is finally emitted, which means a considerable portion of the light is lost by a variety of ways, such as optical loss, emission loss, and the like. Therefore, it becomes an important research direction of the current electroluminescence field to reduce the loss of light-emitting light during the luminescence process and to enhance the light extraction rate.

Some of the most commonly method to improve light extraction rate is to prepare a top-emitting device and employ various materials with high refraction index in the light emitting surface. However, since the overall performance of top-emitting devices is still low, they are far from entering the application stage.

### SUMMARY OF THE INVENTION

It is one object of the present invention to provide an organic electroluminescent device with a higher light extraction rate and a conductive substrate thereof.

A conductive substrate for an organic electroluminescent device includes a glass substrate; an ITO layer; and a metal oxide layer sandwiched between the glass substrate and the ITO layer; wherein a refractive index of the metal oxide layer is ranged between the refractive indexes of the glass substrate and the ITO layer.

In a preferred embodiment, the metal oxide layer is made of a material selected from the group consisting of MgO, ZrO, and Al₂O₃.

In a preferred embodiment, the metal oxide layer has a thickness of 50nm to 150nm.

In a preferred embodiment, the ITO layer has a thickness of 100nm to 200nm.

An organic electroluminescent device includes a conductive substrate, and a hole injection layer, a hole transport layer, a light emitting layer, an electron transport layer, an electron injection layer, and the metal cathode, which are laminated on the conductive substrate in that order. The conductive substrate includes a glass substrate; an ITO layer; and a metal oxide layer sandwiched between the glass substrate and the ITO layer; wherein a refractive index of the metal oxide layer is ranged between the refractive indexes of the glass substrate and the ITO layer.

In a preferred embodiment, the hole injection layer is made of a material selected from the group consisting of molybdenum trioxide, tungsten trioxide, and VOₓ. In a preferred embodiment, the hole transport layer is made of a material selected from the group consisting of N, N'-bis (3 - methylphenyl)-N, N'-diphenyl-4, 4'- biphenyl diamine, N, N'-(1 - naphthyl)-N, N'-diphenyl-4, 4'- biphenyl diamine, 1,3,5-triphenylbenzene, and CuPc.

In a preferred embodiment, the light emitting layer is made of a material selected from the group consisting of tetra(tert-butyl)perylene, 4 - (nitrile methyl) -2 - butyl-6 - (1,1,7,7 - tetramethyl piperidine gyula it -9 - ethenyl)-4H-pyran, 9,10 - naphthylene-β-anthracene, bis (2 - methyl - 8 - hydroxyquinoline) - (4 - diphenol) aluminum, 4 - (methyl nitrile enyl) -2 - isopropyl-6 - (1,1,7,7 - tetramethyl piperidine gyula it -9 - ethenyl)-4H-pyran, dimethyl quinacridone, and 8 - hydroxyquinoline aluminum quinoline.

In a preferred embodiment, the electron transport layer is made of a material selected from the group consisting of 2 - (4 - biphenylyl) -5 - (4 - tert-butyl) phenyl-1, 3,4 - oxadiazole, 8 - hydroxyquinoline aluminum quinoline, 2,5 - bis (1 - naphthyl) -1,3,4 - oxadiazole, 1,2,4 - triazole derivative, N-aryl benzimidazole, and quinoxaline derivative.

In a preferred embodiment, the electron injection layer is made of a material selected from the group consisting of LiF, LiO₂, Cs₂O, Al₂O₃, NaF, CsF, CaF₂, MgF₂, NaCl, KCl, RbCl, LiBO₂, and K₂SiO₃.

In the conductive substrate described, since the metal oxide layer which has refractive index ranged between that of the glass substrate and the ITO layer is interposed, light will emits at a interface between ITO/metal oxide, metal oxide/glass, such that the critical angle of total reflection increases relative to the critical angle of without interposing metal oxide, and most of light can be refracted out of the interface while only small portion of light is total reflected, thus the light extraction rate is enhanced.

### BRIEF DESCRIPTION OF THE DRAWINGS

FIG. 1 is a schematic, cross-sectional view of a conductive substrate according to an embodiment of the present disclosure;
FIG. 2 is a schematic, cross-sectional view of an organic electroluminescent device according to an embodiment of the present disclosure;
FIG. 3 is a graph illustrating luminance v. voltage of the organic electroluminescent device of an embodiment and a standard organic electroluminescent device.

### DETAILED DESCRIPTION

Illustrative embodiments of the invention are described below. The following explanation provides specific details for a thorough understanding of and enabling description for these embodiments. One skilled in the art will understand that the invention may be practiced without such details. In other instances, well-known structures and functions have not been shown or described in detail to avoid unnecessarily obscuring the description of the embodiments.

Unless the context clearly requires otherwise, throughout the description and the claims, the words "comprise," "comprising," and the like are to be construed in an inclusive sense as opposed to an exclusive or exhaustive sense; that is to say, in the sense of "including, but not limited to." Words using the singular or plural number also include the plural or singular number respectively. Additionally, the words "herein," "above," "below" and words of similar import, when used in this application, shall refer to this application as a whole and not to any particular portions of this application. When the claims use the word "or" in reference to a list of two or more items, that word covers all of the following interpretations of the word: any of the items in the list, all of the items in the list and any combination of the items in the list.

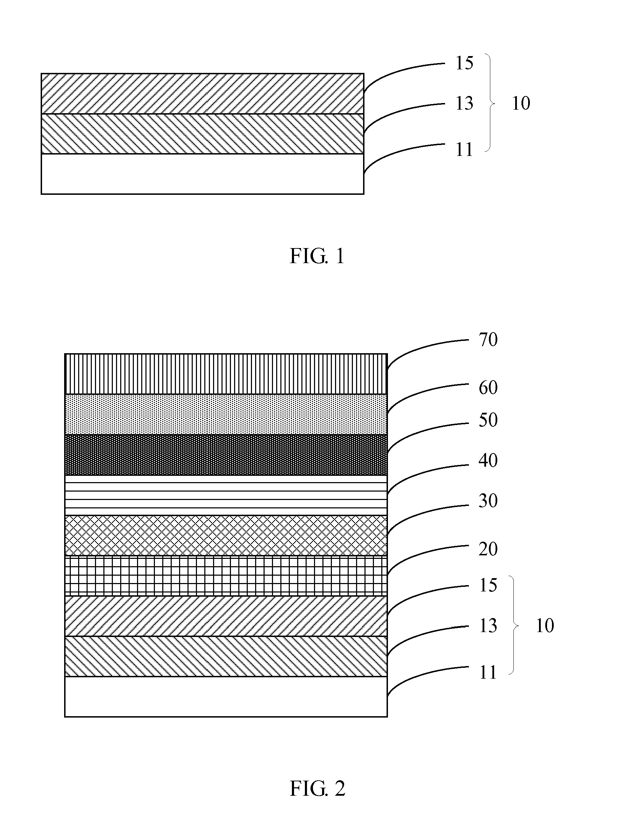

Referring to FIG. 1, an embodiment of a conductive substrate includes a glass substrate 11, an ITO (Indium Tin Oxide) layer 15, and a metal oxide layer 13 sandwiched between the glass substrate 11 and the ITO layer 15. If the refractive index of the ITO layer 15 is donated as n₁, and the refractive index of the glass substrate 11 is donated as n₂, then the refractive index n of the metal oxide layer 13 satisfies: n₁>n> n₂, i.e., the refractive index of the metal oxide layer 13 is ranged between the refractive indexes of the glass substrate 11 and the ITO layer 15.

The refractive index n₁ of the ITO layer 15 is approximately 1.9, the refractive index n₂ of the glass substrate 11 is approximately 1.5. When the light emits from the ITO to the glass substrate directly, a total reflection may occurs due to the law of refraction, which means that all parts of the light is refracted back, no emission. In the illustrated embodiment, the light extraction rate is increased by interposing a metal oxide between the glass substrate and the conductive film without modifying them. The refractive index n of the metal oxide has a relationship with that of the two materials as n₁>n> n₂. In this manner, when the light emits from the ITO to the glass substrate, the angle of total reflection becomes larger (since n> n₂), part of light being total reflected will be reduced, and most of the light can be refracted to the glass substrate; on the other hand, total reflection also occurs between the metal oxide and the glass substrate, when the light emits from the metal oxide, since n<n₁, the refractive index difference between the ITO and the glass is decreased, and the angle of total reflection becomes larger, most of light can be refracted out of an interface thereof. Thus, by the two refractions, the light extraction rate is enhanced, and ultimately the luminous efficiency is improved.

The metal oxide layer 13 is preferably made of a material selected from the group consisting of MgO, ZrO, and Al₂O₃. If the thickness of the metal oxide layer 13 is too thin, the metal oxide layer 13 is easy to be transmitted by light and cause totally reflection; if the thickness of the metal oxide layer 13 is too large, it is difficult for the light to pass through it. Therefore, the thickness of the metal oxide layer 13 is preferably in a range from 50nm to 150nm.

The thickness of the ITO layer 15 is preferably in a range from 100nm to 200nm. The ITO layer with this thickness range has a good film-forming property, a strong adhesion to the metal oxide layer 13, and an enhanced light transmittance.

Referring to FIG. 2, an embodiment of an organic electroluminescent device 100 includes a conductive substrate 10, and a hole injection layer 20, a hole transport layer 30, a light emitting layer 40, an electron transport layer 50, an electron injection layer 60, and the metal cathode 70, which are laminated on the conductive substrate 10 in that order.

The conductive substrate 10 is the conductive substrate shown in FIG. 1.

The hole injection layer 20 is made of a material selected from the group consisting of molybdenum trioxide, tungsten trioxide, and VOₓ.

The hole transport layer 30 is made of a material selected from the group consisting of N, N'-bis (3 - methylphenyl)-N, N'-diphenyl-4, 4'- biphenyl diamine, N, N'-(1 - naphthyl)-N, N'-diphenyl-4, 4'- biphenyl diamine, 1,3,5 - triphenylbenzene, and CuPc.

The light emitting layer 40 is made of a material selected from the group consisting of tetra(tert-butyl)perylene (TBP), 4 - (nitrile methyl) -2 - butyl-6 - (1,1,7,7 - tetramethyl piperidine gyula it -9 - ethenyl)-4H-pyran (DCJTB), 9,10 - naphthylene-β-anthracene (AND), bis (2 - methyl - 8 - hydroxyquinoline) - (4 - diphenol) aluminum (BALQ), 4 - (methyl nitrile enyl) -2 - isopropyl-6 - (1,1,7,7 - tetramethyl piperidine gyula it -9 - ethenyl)-4H-pyran (DCJTI), dimethyl quinacridone (DMQA), and 8 - hydroxyquinoline aluminum quinoline (Alq₃).
The electron transport layer 50 is made of a material selected from the group consisting of 2 - (4 - biphenylyl) -5 - (4 - tert-butyl) phenyl-1, 3,4 - oxadiazole (PBD), 8 - hydroxyquinoline aluminum quinoline (Alq₃), 2,5 - bis (1 - naphthyl) -1,3,4 - oxadiazole (BND), 1,2,4 - triazole derivative (such as TAZ), N-aryl benzimidazole (TPBI), and quinoxaline derivative (TPQ).

The electron injection layer 60 is made of a material selected from the group consisting of LiF, LiO₂, Cs₂O, Al₂O₃, NaF, CsF, CaF₂, MgF₂, NaCl, KCl, RbCl, LiBO₂, and K₂SiO₃.

The metal cathode 70 is made of a material selected from the group consisting of Al, Au, Mg/Ag alloy, Al/Mg alloy, Al/Ca alloy, and Al/Li alloy.

It is to be understood that, other than the described multilayer structure of conductive substrate/hole injection layer/hole transport layer/light emitting layer/electron transport layer/electron injection layer/the metal cathode, the organic electroluminescent device 100 may has any suitable structure, for example, a structure of conductive/ light emitting layer/metal cathode, a structure of conductive substrate/ hole transport layer/ light emitting layer/ electron transport layer/ metal cathode, a structure of conductive substrate / hole injection layer / hole transport layer / light emitting layer / electron injection layer / a metal cathode.

A method of preparing the organic electroluminescent device 100 includes the following steps:

Step one, a commercial glass substrate 11 is ultrasonic cleaned with detergent, acetone, ethanol, and isopropanol, sequentially.

Step two, a metal oxide is deposited on the glass substrate 11 by sputtering, evaporating, or ion plating to form a metal oxide layer 13 having a thickness of 50nm to 150nm.

Step three, ITO is formed on the metal oxide layer 13 by sputtering to form an ITO layer 15 having a thickness of 100nm to 200nm.

Step four, in a vacuum chamber, a hole injection layer 20, a hole transport layer 30, a light emitting layer 40, an electron transport layer 50, an electron injection layer 60, and the metal cathode 70 are evaporated on the ITO layer 15.

Further examples are described in greater details.

Example 1, a commercial glass substrate was ultrasonic cleaned with detergent, acetone, ethanol, and isopropanol, sequentially; then a metal oxide was deposited on the glass substrate by sputtering, evaporating, or ion plating with a thickness of 70nm; ITO was formed on the substrate by sputtering with a thickness of 120nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

Example 2, a commercial glass substrate was ultrasonic cleaned with detergent, acetone, ethanol, and isopropanol, sequentially; then a metal oxide was deposited on the glass substrate by sputtering, evaporating, or ion plating with a thickness of 50nm; ITO was formed on the substrate by sputtering with a thickness of 100nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

Example 3, a commercial glass substrate was ultrasonic cleaned with detergent, acetone, ethanol, and isopropanol, sequentially; then a metal oxide was deposited on the glass substrate by sputtering, evaporating, or ion plating with a thickness of 70nm; ITO was formed on the substrate by sputtering with a thickness of 150nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

Example 4, a commercial glass substrate was ultrasonic cleaned with detergent, acetone, ethanol, and isopropanol, sequentially; then a metal oxide was deposited on the glass substrate by sputtering, evaporating, or ion plating with a thickness of 100nm; ITO was formed on the substrate by sputtering with a thickness of 200nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

Example 5, a commercial glass substrate was ultrasonic cleaned with detergent, acetone, ethanol, and isopropanol, sequentially; then a metal oxide was deposited on the glass substrate by sputtering, evaporating, or ion plating with a thickness of 150nm; ITO was formed on the substrate by sputtering with a thickness of 150nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

Example 6, a commercial glass substrate was ultrasonic cleaned with detergent, acetone, ethanol, and isopropanol, sequentially; then a metal oxide was deposited on the glass substrate by sputtering, evaporating, or ion plating with a thickness of 120nm; ITO was formed on the substrate by sputtering with a thickness of 160nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

Example 7, a commercial glass substrate was ultrasonic cleaned with detergent, acetone, ethanol, and isopropanol, sequentially; then a metal oxide was deposited on the glass substrate by sputtering, evaporating, or ion plating with a thickness of 60nm; ITO was formed on the substrate by sputtering with a thickness of 180nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

Example 8, a commercial glass substrate was ultrasonic cleaned with detergent, acetone, ethanol, and isopropanol, sequentially; then a metal oxide was deposited on the glass substrate by sputtering, evaporating, or ion plating with a thickness of 120nm; ITO was formed on the substrate by sputtering with a thickness of 140nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

Example 9, a commercial glass substrate was ultrasonic cleaned with detergent, acetone, ethanol, and isopropanol, sequentially; then a metal oxide was deposited on the glass substrate by sputtering, evaporating, or ion plating with a thickness of 80nm; ITO was formed on the substrate by sputtering with a thickness of 150nm. The ITO glass was performed with a photolithographic process, and was cut to the desired area for light emitting; the ITO glass was ultrasonic cleaned with detergent, deionized water, acetone, ethanol, and isopropanol, sequentially, each for 15min, so as to remove the organic pollutants on the glass surface. The cleaned glass was performed with an oxygen plasma treatment for 5 to 15min with a power of 10 to 50W. The ITO glass was placed in a vacuum chamber to evaporate various organic layers, and the desired organic electroluminescent device was finally obtained.

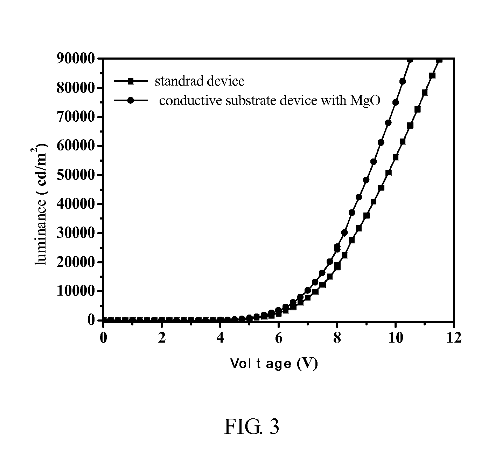

FIG. 3 is a graph illustrating luminance v. voltage of the organic electroluminescent device of Example 1 having a structure of glass substrate/MgO/ITO/MoO₃/NPB/Alq₃/PBD/LiF/Al and a standard organic electroluminescent device.

At a voltage of 6V, the luminance of the device with MgO layer is 3328 cd/cm², while the luminance of the standard device is 2489 cd/cm². As can be seen from the FIG. 3, when the MgO layer is employed, the light extraction rate of the substrate is enhanced, and the loss caused by the total reflection of light is reduced, such that more light can be emitted out by refraction, thus the luminance of the device is enhanced.

Although the invention has been described in language specific to structural features and/or methodological acts, it is to be understood that the invention defined in the appended claims is not necessarily limited to the specific features or acts described. Rather, the specific features and acts are disclosed as sample forms of implementing the claimed invention.

## Claims

1. A conductive substrate for an organic electroluminescent device, comprising:
a glass substrate;
an ITO layer; and
a metal oxide layer sandwiched between the glass substrate and the ITO layer;
wherein a refractive index of the metal oxide layer is ranged between the refractive indexes of the glass substrate and the ITO layer.

2. The conductive substrate for an organic electroluminescent device according to claim 1, wherein the metal oxide layer is made of a material selected from the group consisting of MgO, ZrO, and Al₂O₃.

3. The conductive substrate for an organic electroluminescent device according to claim 1, wherein the metal oxide layer has a thickness of 50nm to 150nm.

4. The conductive substrate for an organic electroluminescent device according to claim 1, wherein the ITO layer has a thickness of 100nm to 200nm.

5. An organic electroluminescent device, comprising a conductive substrate, and a hole injection layer, a hole transport layer, a light emitting layer, an electron transport layer, an electron injection layer, and the metal cathode, which are laminated on the conductive substrate in that order, wherein the conductive substrate comprises:
a glass substrate;
an ITO layer; and
a metal oxide layer sandwiched between the glass substrate and the ITO layer;
wherein a refractive index of the metal oxide layer is ranged between a refractive index of the glass substrate and the ITO layer.

6. The organic electroluminescent device according to claim 5, wherein the hole injection layer is made of a material selected from the group consisting of molybdenum trioxide, tungsten trioxide, and VOₓ.

7. The organic electroluminescent device according to claim 5, wherein the hole transport layer is made of a material selected from the group consisting of N, N'-bis (3 - methylphenyl)-N, N'-diphenyl-4, 4'- biphenyl diamine, N, N'-(1 - naphthyl)-N, N'-diphenyl-4, 4'- biphenyl diamine, 1,3,5 - triphenylbenzene, and CuPc.

8. The organic electroluminescent device according to claim 5, wherein the light emitting layer is made of a material selected from the group consisting of tetra(tert-butyl)perylene, 4 - (nitrile methyl) -2 - butyl-6 - (1,1,7,7 - tetramethyl piperidine gyula it -9 - ethenyl)-4H-pyran, 9,10 - naphthylene-β-anthracene, bis (2 - methyl - 8 - hydroxyquinoline) - (4 - diphenol) aluminum, 4 - (methyl nitrile enyl) -2 - isopropyl-6 - (1,1,7,7 - tetramethyl piperidine gyula it -9 - ethenyl)-4H-pyran, dimethyl quinacridone, and 8 - hydroxyquinoline aluminum quinoline.

9. The organic electroluminescent device according to claim 5, wherein the electron transport layer is made of a material selected from the group consisting of 2 - (4 - biphenylyl) -5 - (4 - tert-butyl) phenyl-1 ,3,4 - oxadiazole, 8 - hydroxyquinoline aluminum quinoline, 2,5 - bis (1 - naphthyl) -1,3,4 - oxadiazole, 1,2,4 - triazole derivative, N-aryl benzimidazole, and quinoxaline derivative.

10. The organic electroluminescent device according to claim 5, wherein the electron injection layer is made of a material selected from the group consisting of LiF, LiO₂, Cs₂O, Al₂O₃, NaF, CsF, CaF₂, MgF₂, NaCl, KCl, RbCl, LiBO₂, and K₂SiO3.
